**Europäisches Patentamt**

**European Patent Office**

**Office européen des brevets**

(19)

(11) Veröffentlichungsnummer: **0 215 290 B1**

# EUROPÄISCHE PATENTSCHRIFT

(12)

(45) Veröffentlichungstag der Patentschrift:
29.11.89

(51) Int. Cl.⁴: **H01L 31/02**

(21) Anmeldenummer: 86111089.8

(22) Anmeldetag: 11.08.86

(54) **Fotoempfindliche Anordnung auf der Basis von a-Si:H für Bildsensoren.**

(30) Priorität: 27.08.85 DE 3530616

(43) Veröffentlichungstag der Anmeldung:
25.03.87 Patentblatt 87/13

(45) Bekanntmachung des Hinweises auf die Patenterteilung:
29.11.89 Patentblatt 89/48

(84) Benannte Vertragsstaaten:
AT CH DE FR GB IT LI NL SE

(56) Entgegenhaltungen:
EP-A- 0 024 970
EP-A- 0 063 694
EP-A- 0 068 456
FR-A- 2 335 053
US-A- 3 969 743

JAPANESE JOURNAL OF APPLIED PHYSICS,
supplements, 1983, 15th conf., Seiten 36,37, Tokyo, JP;
K. SUZUKI et al.: "A4-16 bits/mm contact type high
speed image sensor using an a-Si:H photodetector
array"
PATENTS ABSTRACTS OF JAPAN, Band 5,
Nr. 11 (E-42)[683], 23. Januar 1981; &
JP-A-55 140 275 (FUJITSU K.K.) 01-11-1980

(73) Patentinhaber: Siemens Aktiengesellschaft,
Wittelsbacherplatz 2, D-8000 München 2(DE)

(72) Erfinder: Wieczorek, Herfried, Dipl.-Phys.,
Bereiteranger 5, D-8000 München 90(DE)

## Beschreibung

Die Erfindung betrifft eine fotoempfindliche Anordnung auf der Basis von a-Si:H (= wasserstoffhaltiges, amorphes Silizium) für zeilen- und flächenförmige Bildsensoren, bei der der Fotoleiter aus a-Si:H als Dünnschicht in Sandwichstruktur zwischen zwei metallisch leitenden Elektroden, von denen mindestens eine transparent ausgebildet ist, auf einem, vorzugsweise aus Glas bestehenden Substrat angeordnet ist.

Die Herstellung und der Aufbau von Bildsensoren in Dünnschichttechnik mit Anordnungen der eingangs genannten Art wird beispielsweise in einem Bericht von E. Holzenkämpfer, K. Rosan und K. Kempter in den Proc. of the MRS Europe, Strasbourg (1984) auf den Seiten 575 bis 579 beschrieben.

Ein wichtiges Kriterium für die Güte von fotoempfindlichen Dünnschichtsensoren sind schnelle Responsezeiten. Die Responsezeit ist definiert als die Zeit, in der der Fotostrom auf 3 % seines ursprünglichen Wertes gefallen ist.

Es wurde festgestellt, daß im Randbereich der Elektroden von fotoempfindlichen Dünnschichtsensoren elektrische Streufelder auftreten, wobei fotogenerierte Ladungsträger aus diesen Bereichen an den Elektroden gesammelt werden. Im Unterschied zu den Ladungsträgern, die innerhalb der Sandwichstruktur gesammelt werden, legen die Ladungsträger im Außenbereich einen Weg zurück, der viel größer ist als die Schichtdicke der Fotoleiterschicht, die etwa 1 μm beträgt. Die Abfallzeit des Fotostromes ist daher bei diesen Ladungsträgern viel länger als die Transitzeit in der Sandwichstruktur. Insbesondere bei kleinen Sandwichstrukturen, bei denen der Bereich der Randfelder die Größenordnung der Sensorflächen erreicht (typisch 100 μm²), führt dieser Effekt zu sehr langen Responsezeiten (im Bereich von mehreren Millisekunden) und zum Übersprechen zwischen einzelnen Sensorelementen, weil die Randfelder eines Sensorelements bis zum nächsten Sensorelement reichen können.

JP-A 55 140 275 beschreibt einen Halbleiterdetektor mit guten Hochfrequenzeigenschaften, bei dem die Randbereiche des photoempfindlichen p-n-Übergangs durch eine lichtundurchlässige Maske abgedeckt sind.

Die Aufgabe, die der Erfindung zugrundeliegt, besteht nun darin, Sensoranordnungen zu schaffen, die schnelle Responsezeiten ermöglichen und bei denen das Übersprechen zwischen den einzelnen Sensorelementen vermieden werden kann.

Die Erfindung löst die gestellte Aufgabe bei einer fotoempfindliche Anordnung der eingangs genannten Art dadurch daß eine lichtundurchlässige Maske auf der Lichteinfallseite der transparenten Elektrode vorgesehen ist, die so strukturiert ist, daß die Randbereiche der einzelnen Sensorelemente abgedeckt und nur die eigentlichen Sensorflächen beleuchtet werden.

Dabei liegt es im Rahmen der Erfindung, daß die lichtundurchlässige Maske aus einem entsprechend strukturierten Metallfilm, der zur Vermeidung erhöhter Dunkelströme gegebenenfalls auf einer leicht strukturierbaren, isolierenden Zwischenschicht aus Siliziumdioxid oder Siliziumnitrid erzeugt ist, besteht oder aber aus einer entsprechend strukturierten Lackschicht.

Durch die erfindungsgemäßen Maßnahmen der optischen Abdeckung werden keine Fotoladungsträger im Bereich der Randfelder mehr erzeugt. Die Responsezeit der Sensoren kann so auf Werte unter einer Mikrosekunde verringert werden. Das Übersprechen zwischen einzelnen Sensorelementen wird stark gedämpft.

Die Erfindung wird im folgenden anhand der Figuren 1 bis 3 noch näher erläutert. Dabei zeigt

die Figur 1 im Schnittbild den Aufbau einer Sensorzeile (Ausschnitt),

die Figur 2 eine Draufsicht auf den Sensorzeilenaufbau nach Figur 1 und

die Figur 3 in einem Kurvendiagramm den Unterschied der Responsezeiten mit und ohne optische Abschirmung.

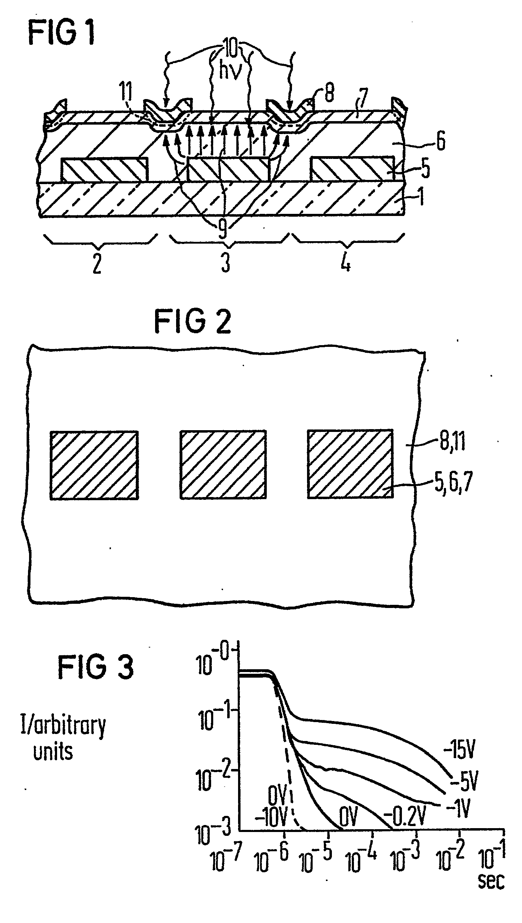

Figur 1: Auf einem Glassubstrat 1 wird die Sensorzeile, bestehend aus den Sensorelementen 2, 3, 4 in bekannter Weise mit folgendem Schichtaufbau erzeugt:

5 = metallische Grundelektrode, zum Beispiel aus Titan, 300 nm,

6 = Fotoleiterschicht aus a-Si:H, ca. 1000 nm, 11 = isolierende Zwischenschicht aus $SiO_2$ oder Siliziumnitrid

7 = transparente Deckelektrode, zum Beispiel aus Indium-Zinnoxid (ITO), 100 nm,

8 = optische Abschirmmaske, zum Beispiel aus Gold, 300 nm.

Die geraden Pfeile 9 zeigen das zwischen der Grundelektrode 5 und der Deckelektrode 7 in der Fotoleiterschicht 6 vorhandene elektrische Feld des Sensorelements 3 an, die gewellten Pfeile 10 das auf die Sensorzeile 3 einfallende Licht (hν).

Wie aus der Figur 2 ersichtlich ist, bedeckt die optische Abschirmmaske 8 und die Zwischenschicht 11 die ganze Struktur mit Ausnahme der mit einer Schraffur versehenen Sandwichflächen (5, 6, 7) der einzelnen Sensorelemente (2, 3, 4).

Aus Figur 3 ist das Abklingen des Fotostroms an einem Dünnschichtsensor abhängig von der angelegten Spannung ersichtlich. Dabei ist im logarithmischen Maßstab als Ordinate das Fotostromsignal I in a. u. (= arbitrary units = willkürliche Einheiten) und als Abszisse die Zeit nach Abklingen der Beleuchtung in Sekunden aufgetragen. Die durchgezogenen Kurven ergeben sich aus den Messungen bei ganzflächiger Beleuchtung des Sensors; die gestrichelte Kurve wurde mit der erfindungsgemäßen Sensoranordnung gemessen.

## Patentansprüche

1. Fotoempfindliche Anordnung auf der Basis von wasserstoffhaltigem, amorphem Silizium a-Si:H für zeilen- und flächenförmige Bildsensoren, bei der der Fotoleiter aus a-Si:H als Dünnschicht in Sandwichstruktur zwischen zwei metallisch leitenden Elektroden, von denen mindestens eine transparent ausgebildet ist, auf einem, vorzugsweise aus Glas bestehenden Substrat angeordnet ist, **dadurch gekennzeichnet**, daß eine lichtundurchlässige Maske (8) auf der Lichteinfallseite (hν) der transparenten Elektrode (7) vorgesehen ist, die so strukturiert ist, daß die Randbereiche der einzelnen Sensorelemente (2, 3, 4) abgedeckt und nur die eigentlichen Sensorflächen (5, 6, 7) beleuchtet werden.

2. Sensoranordnung nach Anspruch 1, **dadurch gekennzeichnet**, daß die lichtundurchlässige Maske (8) aus einem strukturierten Metallfilm besteht.

3. Sensoranordnung nach Anspruch 2, **dadurch gekennzeichnet**, daß der Metallfilm (8) auf einer leicht strukturierbaren, isolierenden Zwischenschicht (11) aus SiO₂ oder Siliziumnitrid erzeugt ist.

4. Sensoranordnung nach Anspruch 1, **dadurch gekennzeichnet**, daß die lichtundurchlässige Maske (8) aus einer strukturierten Lackschicht besteht.

**Claims**

1. Photosensitive arrangement, based on hydrogen-containing, amorphous silicon a–Si:H, for linear and planar image sensors, in which arrangement the photoconductor of a–Si:H is arranged as a thin layer in a sandwich structure between two metallically conducting electrodes, of which at least one is of transparent construction, on a substrate, preferably consisting of glass, characterized in that an opaque mask (8) is provided on the light incidence side (hν) of the transparent electrode (7) which is structured so that the edge regions of the individual sensor elements (2, 3, 4) are covered and only the actual sensor surfaces (5, 6, 7) are illuminated.

2. Sensor arrangement according to Claim 1, characterized in that the opaque mask (8) consists of a structured metal film.

3. Sensor arrangement according to Claim 2, characterized in that the metal film (8) is produced from an easily structurable, insulating intermediate layer (11) of SiO₂ or silicon nitride.

4. Sensor arrangement according to Claim 1, characterized in that the opaque mask (8) consists of a structured varnish layer.

**Revendications**

1. Dispositif photosensible formé à base de silicium amorphe, contenant de l'hydrogène, a–Si:H pour des détecteurs d'images de forme linéaire et des détecteur d'images possédant une certaine étendue en surface, et dans lequel le photoconducteur constitué par du a–Si:H est déposé sous la forme d'une couche mince selon une structure sandwich entre deux électrodes métalliques conductrices, dont l'une au moins est transparente, sur un substrat réalisé de préférence en verre, caractérisé par le fait que sur le côté d'incidence de la lumière (hν) de l'électrode transparente (7), il est prévu un masque opaque (8) structuré de manière que les zones marginales des différents éléments de détection (2, 3, 4) sont masqués et que les surfaces proprement dites de détection (5, 6, 7) sont éclairées.

2. Dispositif de détection suivant la revendication 1, caractérisé par le fait que le masque opaque (8) est constitué par une pellicule métallique structurée.

3. Dispositif de détection suivant la revendication 2, caractérisé par le fait que la pellicule métallique (8) est formée sur une couche intercalaire isolante (11), pouvant être aisément structurée, constituée par du SiO₂ ou du nitrure de silicium.

4. Dispositif de détection suivant la revendication 1, caractérisé par le fait que le masque opaque (8) est constitué par une couche de peinture structurée.

## FIG 1

## FIG 2

## FIG 3

I/arbitrary
units